Europäisches Patentamt

European Patent Office

Office européen des brevets

(11) Publication number: **0 174 060**
**B1**

(12) **EUROPEAN PATENT SPECIFICATION**

(45) Date of publication of patent specification: **11.01.89**

(21) Application number: **85303251.4**

(22) Date of filing: **08.05.85**

(51) Int. Cl.⁴: **C 30 B 15/10,** C 30 B 27/02, C 30 B 29/40

(54) Method for growing a single crystal.

(30) Priority: **08.06.84 JP 117845/84**

(43) Date of publication of application:
**12.03.86 Bulletin 86/11**

(45) Publication of the grant of the patent:
**11.01.89 Bulletin 89/02**

(84) Designated Contracting States:
**DE FR GB**

(56) References cited:
**EP-A-0 138 292**
**EP-A-0 139 157**
**EP-A-0 146 002**
**FR-E-2 038 715**

(73) Proprietor: **SUMITOMO ELECTRIC INDUSTRIES LIMITED**
**No. 15, Kitahama 5-chome Higashi-ku Osaka-shi Osaka 541 (JP)**

(72) Inventor: **Tada, Koji c/o Osaka Works Sumitomo Electric Ind. Ltd. 1-3, Shimaya 1-chome**
**Konohana-ku Osaka (JP)**
Inventor: **Tatsumi, Masami c/o Osaka Works Sumitomo Electric Ind. Ltd. 1-3, Shimaya 1-chome**
**Konohana-ku Osaka (JP)**
Inventor: **Kotani, Toshihiro c/o Osaka Works Sumitomo Electric Ind. Ltd. 1-3, Shimaya 1-chome**
**Konohana-ku Osaka (JP)**
Inventor: **Sawada, Shinichi c/o Osaka Works Sumitomo Electric Ind. Ltd. 1-3, Shimaya 1-chome**
**Konohana-ku Osaka (JP)**

(74) Representative: **Stebbing, Peter John Hunter et al**
**F.J. CLEVELAND & COMPANY 40-43, Chancery Lane**
**London WC2A 1JQ (GB)**

Courier Press, Leamington Spa, England.

## Description

This invention relates to a method for growing a single crystal of compound semiconductors.

Single crystals of compound semiconductors are widely applicable; for example as substrates for integrated circuits, light emitting diodes for various kinds of detecting devices.

According to a required purpose semi-insulating, *n*-type or *p*-type single crystals are grown.

The compound semiconductors referred to herein are the compound semiconductors of groups III—V and groups II—VI of the periodic table.

The compound semiconductors of groups III—V are for example, InP, InAs, GaAs, GaP, InSb or GaSb. The compound semiconductors of groups II—IV are for example ZnSe, CdTe or ZnS.

Conventionally there are several methods of manufacturing single crystals of compound semiconductors; the liquid encapsulated Czochralski method (LEC) and the horizontal Bridgman method (HB) are the most preferable for industrial production.

The horizontal Bridgman method is a boat method which grows a single crystal in a boat by moving temperature distribution in a horizontal direction.

The best method among the pulling methods is the LEC method, which grows a single crystal by pulling up a seed crystal from a compound melt covered by a liquid encapsulant in a crucible. A description of this process is to be found in our EP—A—0,092,409.

Manufacturing of compound semiconductors of groups III—V has a problem in that it is difficult to make a stoichiometric single crystal because of high dissociation pressure of elements of group V.

In a LEC method in order to prevent the elements of group V escaping, a material melt is covered with a liquid encapsulant which is acted upon by an inert or nitrogen gas at high pressure. The liquid covering the material melt is called a liquid encapsulant. The liquid encapsulant effectively prevents the escape of the elements of group V. However some portion of the elements volatilize through the pressurized liquid encapsulant.

The liquid encapsulant must be strongly pressurized, so the whole apparatus is enclosed by a pressure vessel, and inert or nitrogen gas fills the pressure vessel at a pressure of up to several MPa (0.1 MPa = 1 atmosphere).

Because pressurized gas fills the pressure vessel, vigorous gas convection occurs. The atmosphere in the vessel is therefore thermally unstable. Therefore the single crystal is forcibly cooled immediately after it has been pulled above the melt, so thermal stress is apt to occur in the crystal grown. Strong thermal stress heightens the dislocation density of the crystal, This is a serious defect in a conventional LEC method.

A novel pulling method for crystal growth has also been proposed. The vertical vapor-pressure-controlling method has been proposed in European Patent Publication No. 0,139,157 (published 24.04.85) and No. 0,146.002 (published 26.06.85).

Unlike the LEC method wherein the crucible is heated locally in the vapour-pressure-controlling method the whole of the pressure vessel is heated from top to bottom. Therefore the temperature gradient in a vertical direction is much smaller than that in LEC method. Further vapour-pressure-controlling method uses no liquid encapsulant. The material melt in a crucible contacts and keeps equilibrium with a selected gas in the pressure vessel at a relatively low pressure.

Furthermore the gas in the vessel is not an inert gas nor nitrogen gas, but a gas of an element of group V. A lump of an element of group V is placed at a suitable position in the vessel and is heated to a desired temperature to provide a desired vapor pressure of the element of group V in the vessel.

Because the vapor pressure of the element of group V maintains an equilibrium through the vessel, the vapor pressure of the element of group V in the material melt in the crucible is determined by the vapor pressure at the lowest temperature in the vessel.

This method is a pulling method for crystal growth of a single crystal and is effected by dipping a seed crystal into a material melt and pulling a single crystal progressively to produce a seed crystal.

The pressure in the vessel is not so high as mentioned before. In many cases, the pressure is about 0.1 MPa (1 atm) or slightly more.

The vertical vapour-pressure-controlling method is similar to an imaginary method which would be obtained by verticalizing the horizontal Bridgman method. The temperature of the upper space in the vessel is kept at about 650°C in the case of GaAs crystal growth.

By keeping the equilibrium of the vapor pressure in the vessel and preventing the volatilization of the elements of group V from the melt, a stoichiometric single crystal can be provided.

In principle this newly-proposed vertical vapour-pressure-controlling method is an excellent method. However the gas in the vessel is only the gas of the element of group V without an inert or nitrogen gas, so the gas pressure is much smaller than that in conventional LEC methods. The fluctuation of vapor pressure is therefore considerable. These fluctuations make it difficult to control the vapor pressure of the element of group V in the vessel since this is controlled by heating the coldest part of the vessel at a predetermined temperature.

However a slight change of temperature causes a large change of vapor pressure of the element of group V, and subtle pressure control is difficult. Therefor the elements of group V are inclined to volatilize from a material melt or a growing crystal.

On these grounds the vertical vapour-pressure-controlling method has the defects that it requires a complex apparatus and operation.

EP—A-0 162 467 (published 27.11.85) provides an inner vessel disposed within an outer vessel, a plurality of heaters spaced sequentially between the inner and outer vessels, an upper rotatable shaft penetrating the inner vessel via an aperture and movable up and down, a lower rotatable shaft penetrating the inner vessel via an aperture and movable up and down, a lower rotatable shaft penetrating the inner vessel via a lower aperture and movable up and down, said lower and upper apertures being provided with an encapsulant material to seal the shafts relative to the inner vessel and a crucible supported upon the lower shaft.

The method of the prior art also provides charging a semiconductor material, an encapsulant material and optionally an impurity element into a crucible disposed within the inner vessel.

charging said inner vessel with an inactive gas, sealing the inner vessel relative to the outer vessel by heating encapsulant materials into liquid encapsulants, melting the materials within the crucible and pulling up the seed crystal therefrom.

The present invention is characterised by causing the volatilization by heat of a solid element of groups V or II within the inner vessel to maintain the partial pressure $Q_o$ of the element of groups V or II at least equal to the dissociation pressure $Q_d$ of the elements V or II at seeding temperatures, and controlling the total pressure within the inner vessel to a value at least equal to that of the outer vessel.

The following is a description by way of example only and with reference to the accompanying drawings of method of carrying the invention into effect.

In the drawings:

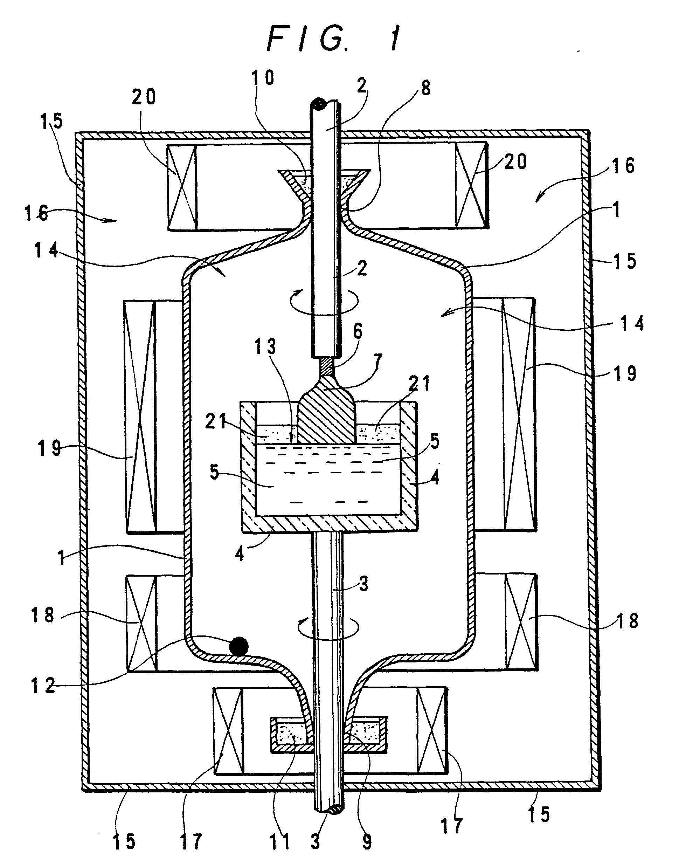

Fig. 1 is a sectional view of an apparatus for growing a single crystal of the invention.

The structure of the apparatus will be used in this invention for growing a single crystal will be explained with reference to Fig. 1.

The following description relate to the crystal growth of compound semiconductors of groups III—V as an example. The method is also applicable to the crystal growth of compound of semiconductors of groups II—VI.

An inner vessel (1) is an air-tight vessel. An upper shaft (2) penetrates through a top opening (8) of the inner vessel (1). A lower shaft (3) penetrates a bottom opening (9) of the inner vessel (1). Both the upper shaft (2) and the lower shaft (3) can rotate and move up and down.

At the top end of the lower shaft (3) a crucible (4) is fixed. The crucible (4) contains a material melt (5) covered with a liquid encapsulant (21).

The inner vessel (1) must be made from such a material that does not chemically react with hot gas of the element of group V — for example, As, Sb, or P. For example the material of the inner vessel (1) should be quartz, alumina. carbon, nitrides (silicon nitride, boron nitride, aluminium nitride), ceramics, molybdenum or other suitable metals. The inner vessel (1) may be a vessel which is made from a first material and is coated with another suitable material.

The crucible (4) can be made from pyrolytic boron nitride (PBN) for example.

A seed crystal (6) is fitted to the bottom end of the upper shaft (2). The seed crystal (6) is dipped into the material melt (5) and rotated. Then the seed crystal (6) is slowly pulled up. A single crystal (7) is progressively grown on the seed crystal (6).

The structure of the inner vessel (1), contains a device to open or shut the vessel and a device for balancing the pressures between an inner atmosphere and an outer atmosphere. In a rather complex, but in Fig. 1 the inner vessel (1) is simplified. Around the top opening (8) of the upper shaft (2) and the bottom opening (9) of the lower shaft (3), liquid encapsulants (10) and (11) are disposed to prevent the element of group V from escaping from the inner vessel (1).

The liquid encapsulants (21), (10) and (11) are $B_2O_3$ in the case of GaAs crystal growth. They are an eutectic material of NaCl and KCl in case of GaSb.

In this example four heaters are used to realize gentle temperature gradients in the vessel (1).

A first heater (17) heats the bottom of the inner vessel (1). The first heater (17) acts to melt the encapsulant material to a liquid and to seal the inner vessel before the compound material is molten.

A second heater (18) heats the lower part of the inner vessel (1). A lump (12) of an element of group V, for example As or Sb is placed at the lower part of the inner vessel (1). The second heater (18) controls the vapor pressure of the element of group V by adjusting the temperature of the region.

A third heater (19) which is mounted above the heater (18) heats and melts the compound material and the encapsulant material and keeps them in a liquid state.

When the single crystal (7) is pulled up, it is heated by the third heater (19) whereby the temperature in the crystal (7) does not decrease rapidly so that strong thermal stresses do not occur in the single crystal (7) as it is pulled up.

A fourth heater (20) heats the top part of the inner vessel (1). The fourth heater (20) is required to melt the liquid encapsulant (10), about the top opening (8) before the compound material and the encapsulant material in the crucible are molten.

By adjusting and readjusting the output powers of the first to the fourth heaters, an operator grows a single crystal in a gentle temperature gradient in the inner vessel (1).

The pressures of the inert or nitrogen gas and the gas of element of group V effectively suppress the volatilization of the element of group V from the material melt (5) through the liquid encapsulant (21).

Furthermore because the pulled single crystal (7) exists under a partial pressure of the element of group V which partial pressure is bigger than the dissociation pressure at the temperature, the volatilization of the element of group V from the single crystal hardly occurs.

To accomplish the effect abovementioned, this invention controls the pressures of the liquid-encapsulated crucible (4), the inner vessel (1) and the outer vessel (15) as follows.

The outer vessel (15) is filled only with an inert or a nitrogen gas. Strictly speaking the inert gases are helium, neon, argon, krypton and xenon. Nitrogen gas is not exactly called an inert gas, however because nitrogen gas is as chemically stable as an inert gas, it is frequently used as an atmospheric gas in LEC methods.

Therefore the strictly-defined inert gases and nitrogen gas are defined hereinafter as an inactive gas.

According to the definition the outer atmosphere (16) filling in the outer vessel (15) is an inactive gas. The pressure of the outer atmosphere is signified by $P_1$.

The inner atmosphere (14) in the inner vessel (1) comprises an inactive gas and a gas of element of group V. Besides these gases, the inner atmosphere (14) may contain an impurity gas, when an impurity element is doped to adjust the electric properties of the single crystal to n-type, p-type or semi-insulating type. The impurity gas is added to prevent the volatilization of the impurity element from the single crystal as it is pulled up.

$P_0$, $Q_0$, $R_0$ signify the partial pressures of the inactive gas, the gas of element of group V and the impurity gas of the inner atmosphere (14).

In the vertical vapor-pressure-controlling method mentioned before, the atmosphere in the vessel is only the gas of element of group $Q_0$. Thus the method is simply characterised by the conditions $P_0. = 0$ and $R_0 = 0$.

Conventional LEC Methods are characterised by the condition that $Q_0. = 0$, $R_0 = 0$ and $P_0$ is less than several MPa (0.1 MPa = 1 atmosphere).

This invention requires an additional outer vessel (15) enclosing the inner vessel (1). Besides the double vessel structure, this invention requires the following pressure conditions.

(1) $P_0 \neq 0$
(2) $Q_0 \neq 0$, $Q_0 \geqq Q_d$
(3) $P_0 + Q_0 + R_0 \geqq P_1$

Where $C_d$ is the dissociation pressure of the element of the group V, and $P_1$ is the pressure in the outer vessel.

Namely the partial pressure $Q_0$ of the element of group V in the inner vessel should be equal to or bigger than the dissociation pressure $Q_d$. The condition signifies the total pressure in the inner vessel (1) should be equal to, or bigger than, the pressure $P_1$ in the outer vessel (15).

In use the outer vessel (15) and the inner vessel (1) are opened. The crucible (4) in which encapsulant material, polycrystal material and impurity element for doping, if necessary are charged, is fixed upon the lower shaft (3). A seed crystal (6) is fitted at the bottom of the upper shaft (2). A lump (12) of the element of group V is placed at a suitable spot in the inner vessel (1).

Encapsulant material (which will be molten into liquid encapsulants (10) and (11)) is supplied to the cavities on the top opening (8) and around the bottom opening (9) of the inner vessel (1). The inner vessel (1) and the outer vessel (15) are then closed.

Inactive gas is supplied to the inner vessel (1) and the outer vessel (15), keeping the pressure valance $P_0 = P_1$.

When a volatile impurity element is added into the crucible (4) for impurity doping, the inner vessel (1) preferably contains the gas of the element with the impurity to prevent the volatilization of the impurity from the single crystal as it is pulled up. The partial pressure of the impurity gas is denoted by $R_0$.

The first heater (17) and the fourth heater (20) are actuated. The encapsulant materials on the top opening (8) and around the bottom opening (9) are thus melted into liquid encapsulants (10) and (11).

The third heater (19) is then actuated to heat the encapsulant material and compound material in the crucible (4). First the encapsulant material is melted into liquid encapsulant (21), which covers the compound material.

Next the compound material is melted into a melt. Between the liquid encapsulant (21) and the material melt (5), a horizontal liquid-liquid interface (13) exists.

Here the compound material is a poly-crystal of compound semiconductor of groups III—V and the impurity dopant.

Instead of compound polycrystal, the compound material can be directly provided in the crucible by charging adequate amounts of individual elements into crucible and heating them up to a desired temperature.

The second heater (18) is then actuated. The lump (12) of the element of group V is thus heated. A part of the lump (12) of the element of group V is sublimated. By the sublimation, the gas of the element of group V gradually fills the inner vessel (1). The partial pressure $Q_0$ of the element of group V thereby increases from 0 MPa (0 atm) to the vapor pressure determined by the temperature.

The partial pressure $Q_0$ can be arbitrarily determined by adjusting the temperature of the lump (12) of the element of group V.

Eventually the partial pressure $Q_0$ of the element of group V becomes uniform in the inner vessel (1). The pressure $Q_0$ must be kept higher than the dissociation pressure of the element at the temperature near the melting point of the compound semiconductor.

The pressure in the inner vessel (1) is $(P_0 + Q_0 + R_0)$. This is equal to or bigger than the pressure $P_1$ of the outer vessel (15). Gas may flow from the inner atmosphere (14) to the outer atmosphere (16) through the liquid encapsulants (10) and (11). But it is quite impossible that gas flows from the outer atmosphere (16) into the inner atmosphere (14).

Under these conditions, the seed crystal (6) is dipped into the material melt (5). The seed crystal (6) and the crucible (4) are rotated. The seed crystal (6) is gradually pulled up. A single crystal (7) is thereby progressively formed.

The advantages of the invention will be explained.

(1) This invention enables the growth of a single crystal with low dislocation density.

The single crystal is grown under a gas pressure less than that in a conventional LEC method. The low gas density reduces the vertical temperature gradient near the single crystal, because gas convection is weak. The thermal stress in the crystal is small so that dislocations are hardly generated.

Furthermore because the crystal growth proceeds under an atmosphere of the element of group V, the volatilization of the element of group V is effectively suppressed. By these methods the occurences of lattice defects are conspicuously reduced.

(2) This invention requires no balancing apparatus for adjusting the pressure of the inner atmosphere (14) and the outer atmosphere (16). The volatilization of the element of group V from the material melt and the crystal is effectively suppressed only by controlling the pressure of the outer atmosphere (16).

If the inner vessel contains only the gas of the element of group V, the vapor pressure $Q_0$ of the element of group V would be controlled within the range from 0 to several MPa (0.1 MPa = 1 atmosphere). Especially if the vapor pressure is high, the dissociation pressure would greatly change upon a small change of the temperature of the second heater (18). It would thus be difficult to keep the inner atmosphere (14) at a desired pressure. Such difficulty of pressure control is the defect of using a single atmosphere gas in the inner vessel.

In this invention the inner vessel (1) contains an inactive gas and a gas of the element group V, the pressure of the inner atmosphere (14) is the sum of the pressure $P_0$ of the inactive gas and the pressure $Q_0$ of the gas of the element of group V. $Q_0$ may be equal to, or slightly greater than, the dissociation pressure of the gas of group V to prevent the volatilization of the element of group V from the grown crystal. In this case $Q_0$ is small.

Because $Q_0$ is small, the vapor pressure $Q_0$ changes very slightly upon a considerable change of the temperature of the second heater (18). Furthermore the pressure $P_0$ of the inactive gas is an independent variable. The inner atmosphere (14) can be pressurized to a desired high pressure by supplying inactive gas into the inner vessel (1).

As shown in Fig. 1 the material melt (5) is encapsulated by the liquid encapsulant (21), which is acted upon by total pressure $(P_0 + Q_0)$. Because the pressure $P_0$ can be independently adjusted, the pressure acting on the liquid encapsulant (21) can be controlled. The independent

adjustability of $P_0$ enables the prevention of the volatilization of the element of group V from the material melt (5).

To prevent the volatilization of the element of group V from the crystal (7), the partial pressure $Q_0$ of the element of group V must be slightly higher than the dissociation pressure of the element of group V on the surface of the crystal.

Temperature control of the second heater (18) is easy, because the change of temperature does not cause a significant change of vapor pressure $Q_0$. Stable temperature distribution is realized near the crucible. This ensures a stable growth of a single crystal.

(4) The structure of the apparatus is simple; the operation is easy. This invention does not require a device for watching the pressure balance between the inner and outer atmospheres, nor a device for readjusting the pressure balance. This invention only requires that a suitable vapor pressure $Q_0$ of the element of group V exists in ther inner vessel.

The advantages can also be obtained, when this method is applied to the crystal growth of compound semiconductors of groups II—VI.

Example 1 (InAs)

This invention is applied to the crystal growth of an InAs single crystal.

InAs polycrystal, encapsulant material $(B_2O_3)$ and 0.5 wt% of Ga element are charged into a crucible. An As lump is positioned in the inner vessel. Nitrogen gas is filled into the inner vessel and into the outer vessel at a pressure of up to 0.17 MPa (1.7 atm). The first heater (17) and the fourth heater (20) are actuated. Liquid encapsulants (10) and (11) thereby seal the openings (8) and (9).

Heating of the InAs polycrystal in the crucible is started at the same time as heating the As-lump (12). The encapsulant material is melted to a liquid encapsulant which covers the InAs polycrystal. The InAs polycrystal then also melts.

The temperature of the As-lump (12) is adjusted by changing the output power of the second heater (18).

The dissociation pressure of As in the InAs melt at seeding is 0.033 MPa (0.33 atm). Then the output of the second heater (18) is adjusted to keep the As-lump (12) at 590°C, which is the temperature to keep the As-vapor pressure within the range from 0.333 to 0.1 MPa (0.33 atm to 1 atm).

The inner atmosphere (14) contains both As gas and $N_2$ gas. The total pressure in the inner atmosphere (14) is 0.2 to 0.21 MPa (2.0 to 2.1 atm).

The outer atmosphere $P_1$ (16) contains only 0.2 MPa (2 atm) of nitrogen gas. Total inner pressure $(P_0 + Q_0 + R_0)$ in the inner vessel is equal to or more than the outer pressure $P_1$.

The heated As-lump (12) then sublimes. The vapor pressure $Q_0$ increases from 0MPa (0 atm) to a desired pressure. Excess nitrogen gas flows to the outer vessel (15) through the liquid encapsulants (10) and (11). This flow equalizes the pressures between the inner vessel and the outer vessel. But the gas does not flow from the outer vessel (15) to the inner vessel (1) because the inner pressure is higher than the outer pressure.

Crystal growth occurs upon rotation of the crucible at 6 revolutions per minute and at the pulling speed of 3 to 6 mm/h.

Under these conditions an InAs single crystal is grown having a diameter of 50 mm, and a length of 180 mm.

As cannot escape from the grown crystal and the dislocation density in the crystal is small.

In general the dissociation pressure of As-solid (As-lump (12)) is changed considerably by a small change of temperature. Therefore controlling of the pressure of As by adjusting the temperature of As-solid is difficult.

However this invention only requires the adjustment of the temperature of As-lump which generates 0.033 to 0.1 MPa (0.33 to 1 atm) of As vapor pressure at seeding. The allowable range of temperature is wide.

This ensures an easy control of the temperature of As-lump.

### Example II

A GaAs single crystal doped with 0.6 wt% of Cr is grown in this example; the liquid encapsulant is $B_2O_3$.

The dissociation pressure of As at seeding is about 0.1 MPa (1 atm). The pressures of nitrogen gas both in the outer vessel (15) and the inner vessel (1) are adjusted to a value between 0.1 and 2 MPa (1 to 20 atm).

Polycrystal material, encapsulant material and Cr as impurity are charged into crucible. The crucible is set on the lower shaft (3). Encapsulant materials are added to the cavity about the openings (10) and (11).

The inner vessels are closed. The encapsulant materials are melted to liquify encapsulants (10) and (11) by the heaters (17) and (20). The second heater (18) and the third heater (19) are actuated. The As-lump (12) is heated and starts to sublime, while the encapsulant material (21) also melts to provide molten polycrystal.

The output power of the heater (18) is adjusted to keep the temperature of the As-lump (12) at about the 650°C. This temperature holds the As vapor pressure $Q_0$ within the range from 0.1 to 0.2 MPa (1 to 2 atm).

A cr-doped single crystal is grown under these conditions. The crucible rotation is 1 to 10 rpm. The pulling speed is 3 to 10 mm/h. The single crystal grown is 60 mm in diameter and 120 mm in length.

No evidence of As-escaping from the crystal is found. Dislocations and other lattice defects are much reduced so as to provide a single crystal of high quality.

No As escaped from the rest of the material in the crucible.

## Claims

1. A method for growing a single crystal (7) of a semiconductor compound (5) of groups III—V or II—V of the periodic table which method comprises;

charging a semiconductor material (5), an encapsulant material (21) and optionally an impurity element into a crucible (4) disposed in an inner vessel (1), charging said inner vessel with an inactive gas (14),

sealing the inner vessel relative to an outer vessel by heating an encapsulant sealing material (10, 11) into liquid encapsulants,

melting the materials within the crucible (14) and pulling up a seed crystal (7) therefrom, characterized by causing the volatilization by heat of a solid element (12) of the group V or II within the inner vessel to maintain the partial pressure $Q_0$ of the element of groups V or II at least equal to the dissociation pressure $Q_d$ of the elements V or II at seeding temperatures,

and controlling the total pressure within the inner vessel (1) to a value at least equal to that of the outer vessel (15).

2. A method for growing a single crystal as claimed in claim 1 wherein the semiconductor compound is InAs, the liquid encapsulant is $B_2O_3$, the inactive gas is nitrogen gas and the partial pressure of As is kept within the range of 0.03 to 0.1 MPa (0.3 to 1 atm) during crystal growth.

3. A method for growing a single crystal according to claim 1 wherein the semiconductor compound is GaAs, the liquid encapsulant is $B_2O_3$, the inactive gas is nitrogen gas, and the partial pressure of As is kept within the range of 0.1 to 0.2 MPa (1 to 2 atm) during crystal growth.

### Patentansprüche

1. Verfahren zum Züchten eines Einkristalls (7) aus einem III—V oder II-VI-Verbindungshalbleiter (5), umfassend — Einbringen eines Halbleitermaterials (5), eines Verkapselungsmaterials (21) und gegebenenfalls eines Fremdstoffelementes in einen Tiegel (4), der in einem inneren Gefäß (1) angeordnet ist, — Beschicken des inneren Gefäßes mit einem Inaktiven Gas (14), — Abschließen des inneren Gefäßes gegenüber einen äußeren Gefäß durch Erwärmen eines Verkapselungs-Abschließmaterials (10, 11) zum Erhalt flüssiger Verkapselungs materialien, — Schmelzen der Materialien innerhalb des Tiegels (4) und Ziehen eines Keimkristalls (7) hiervon, gekennzeichnet durch — Verursachen einer Verdampfung infolge Wärme eines V- oder II-Feststoffelementes (12) innerhalb des inneren Gefäßes, um den Partialdruck $Q_0$ des V- oder II-Elementes wenigstens gleich dem Dissoziationsdruck $Q_d$ des V-oder II-Elementes bei Kleimbildungs temperaturen zu halten, und — Steuern des Gesamtdruckes innerhalb des inneren Gefäßes (1) auf einem Wert, der wenigstens gleich dem des äußeren Gefäßes (15) ist.

2. Verfahren zum Züchten eines Einkristalles wie in Anspruch 1 beansprucht, bei dem — der Verbindungshalbleiter InAs ist, — das flüssige Verkapselungsmaterial $B_2O_3$ ist, — das inaktive Gas Stickstoffgas ist und — der Partialdruck von As während der Kristallzüchtung im Bereich von 0,03 bis 0,1 MPa (0,3 bis 1 Atm.) gehalten wird.

3. Verfahren zum Züchten eines Einkristalls nach Anspruch 1, bei dem — der Verbindungshalbleiter GaAs ist, — das flüssige Verkapselungsmaterial $B_2O_3$ ist, — das inaktive Gas Stickstoffgas ist und — der Partialdruck von As während der Kristallwachstums im Bereich von 0,2 bis 0,2 MPa (1 bis 2 Atm.) gehaltend wird.

**Revendications**

1. Une méthode ou procédé de tirage d'un monocristal (7) de composé semiconducteur (5) des groupes III—V ou II-VI de la table périodique, qui comporte la chargement d'un matériau semiconducteur (5), d'un matériau d'encapsulage (21) et en option d'un élément d'impureté dans un creuset (4) disposé dans un récipient intérieur (1), le remplissage dudit récipient intérieur par un gaz inactif (14), le scellement du récipient intérieur par rapport à un récipient extérieur en chauffant un matériau de scellement d'encapsulage (10, 11) pour obtenir des encapsulages liquides, la fusion des matériaux dans le creuset (4) et le tirage d'un cristal germe (7) du creuset, caractérisé par la volatilisation par la chaleur d'un élément solide (12) du groupe V ou II dans le récipient intérieur pour maintenir la pression partielle $Q_0$ de l'élément des groupes V ou II au moins égale à la pression de dissociation $Q_d$ des éléments V ou II aux températures de germination, et le contrôle de la pression totale dans le récipient intérieur (1) pour la maintenir à une valeur au moins égale à celle du récipient extérieur (15).

2. Un procédé de tirage d'un monocristal selon la revendication 1 dans lequel le composé semiconducteur est du InAs, le liquide d'encapsulage est du $B_2O_3$, le gaz inactif est de l'azote et où la pression partielle de l'As est maintenue dans les limites de 0,03 à 0,1 MPa (0,3 à 1 atm) au cours du tirage du cristal.

3. Un procédé de tirage d'un monocristal selon la revendication 1 selon lequel le composé semiconducteur est du GaAs, le liquide d'encapsulage est du $B_2O_3$, le gaz inactif est de l'azote et où la pression partielle de l'As est maintenue dans les limites de 0,1 à 0,2 MPa (1 à 2 atm) au cours du tirage du cristal.

EP 0 174 060 B1

## F I G.  1